# EUROPÄISCHE PATENTSCHRIFT

(11) **EP 1 033 814 B1**
(45) Veröffentlichungstag und Bekanntmachung des Hinweises auf die Patenterteilung: **26.03.2008**
(21) Anmeldenummer: 00104145.8
(22) Anmeldetag: 29.02.2000
(51) Int. Cl.: H03K 3/356, H03K 5/151

(54) **Integrierte Schaltung zur Erzeugung zweier Ausgangstakte mit zeitlich nicht überlappenden Pegeln**
Integrated circuit for generating two non-overlapping clock signals
Circuit intégré pour la génération de deux signaux d'horloge sans chevauchement

(30) Priorität: 04.03.1999 DE 19909536
(43) Veröffentlichungstag der Anmeldung: 06.09.2000
(73) Patentinhaber: Qimonda AG, 81739 München (DE)
(72) Erfinder: Heyne, Patrick, 81541 München (DE); Graetz, Thoralf, 01309 Dresden (DE); Härle, Dieter, 81541 München (DE)
(74) Vertreter: Epping - Hermann - Fischer

(56) Entgegenhaltungen:
- US-A- 5 874 845
- PATENT ABSTRACTS OF JAPAN Bd. 007, Nr. 123 (E-178), 27. Mai 1983 (1983-05-27) & JP 58 040922 A (HITACHI SEISAKUSHO KK), 10. März 1983 (1983-03-10)
- PATENT ABSTRACTS OF JAPAN Bd. 014, Nr. 374 (E-0964), 13. August 1990 (1990-08-13) & JP 02 135815 A (MITSUBISHI ELECTRIC CORP), 24. Mai 1990 (1990-05-24)

## Beschreibung

Die Erfindung betrifft eine integrierte Schaltung zur Erzeugung zweier Ausgangstakte, wobei erste logische Pegel der Ausgangstakte sich zeitlich nicht überlappen.

Derartige Schaltungen werden beispielsweise zur Ansteuerung von Schieberegistern benötigt, bei denen mehrere Registerelemente in einer Reihenschaltung angeordnet sind, die über Schaltelemente miteinander verbunden sind. Hierbei ist es wichtig, daß zu keinem Zeitpunkt sowohl das eingangsseitige als auch das ausgangsseitige Schaltelement eines der Registerelemente leitend ist. Daher ist es günstig, beide Schaltelemente mit jeweils unterschiedlichen Takten anzusteuern, wobei die Schaltelement bei einem ersten logischen Pegel der Taktsignale leiten und beim anderen logischen Pegel sperren. Um ein gleichzeitiges Leiten beider Schaltelemente zu vermeiden, ist es notwendig, daß sich die ersten logischen Pegel der beiden Taktsignale zeitlich nicht überlappen.

Der Erfindung liegt die Aufgabe zugrunde, eine integrierte Schaltung anzugeben, mit der zwei Ausgangstakte erzeugt werden können, die erste logische Pegel haben, die sich zeitlich nicht überlappen. Außerdem soll die Zeitspanne, während der keiner der Ausgangstakte den ersten logischen Pegel aufweist, möglichst kurz sein.

Diese Aufgabe wird mit einer integrierten Schaltung gemäß Patentanspruch 1 gelöst. Vorteilhafte Aus- und Weiterbildungen der Erfindung sind Gegenstand der abhängigen Patentansprüche.

Die Erfindung ermöglicht die Erzeugung der beiden Ausgangstakte, deren erste logische Pegel sich zeitlich nicht überlappen, aus zwei Eingangstakten, deren logische Pegel sich zeitlich beliebig überlappen dürfen.

Nach einer Weiterbildung der Erfindung sind die Ausgänge jeweils mit einer Verzögerungseinheit verbunden, die eine unterschiedliche Verzögerung für die beiden Flankenarten des jeweiligen Ausgangstaktes bewirkt. Auf diese Weise läßt sich vorteilhaft die Zeitspanne, während der keiner der Ausgangstakte den ersten logischen Pegel aufweist, minimieren.

Die Erfindung wird im folgenden anhand der Figuren näher erläutert, die Ausführungsbeispiele darstellen. Es zeigen:
- Figuren 1 bis 3: verschiedene Ausführungsbeispiele der erfindungsgemäßen integrierten Schaltung und
- Figuren 4 bis 6: Signalverläufe zu den in den Figuren 1 bis 3 dargestellten Ausführungsbeispielen.

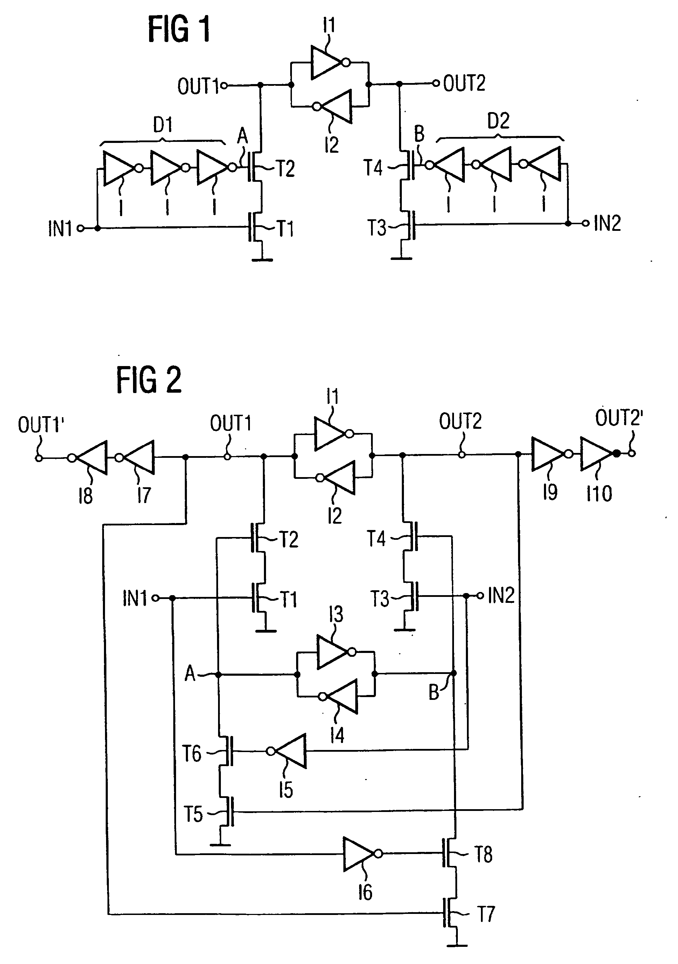

Figur 1 zeigt ein erstes Ausführungsbeispiel der erfindungsgemäßen integrierten Schaltung. Sie weist einen ersten Eingang IN1, einen zweiten Eingang IN2, einen ersten Ausgang OUT1 sowie einen zweiten Ausgang OUT2 auf. Die beiden Ausgänge OUT1, OUT2 sind über zwei antiparallel zueinander angeordnete Inverter I1, I2 miteinander verbunden. Ein niedriges Versorgungspotential Masse ist über ein erstes Schaltelement T1 und ein zweites Schaltelement T2 mit dem ersten Ausgang OUT1 verbunden. Das Massepotential ist außerdem über ein drittes Schaltelement T3 und ein viertes Schaltelement T4 mit dem zweiten Ausgang OUT2 verbunden.

Die bei den hier vorgestellten Ausführungsbeispielen enthaltenen Schaltelemente sind alle n-Kanal-Transistoren. Die Schaltungen sind jedoch auch ebensogut mit p-Kanal-Transistoren realisierbar, wenn statt des Massepotentials ein positives Versorgungspotential verwendet wird.

Der erste Eingang IN1 ist beim Ausführungsbeispiel gemäß Figur 1 mit dem Steueranschluß des ersten Schaltelementes T1 und, über ein erstes invertierendes Verzögerungselement D1, mit dem Gate A des zweiten Schaltelementes T2 verbunden. Der zweite Eingang IN2 ist mit dem Gate des dritten Schaltelementes T3 und, über ein zweites invertierendes Verzögerungselement D2, mit dem Gate B des vierten Schaltelementes T4 verbunden. Die beiden invertierenden Verzögerungselemente D1, D2 weisen je eine Reihenschaltung dreier Inverter I auf.

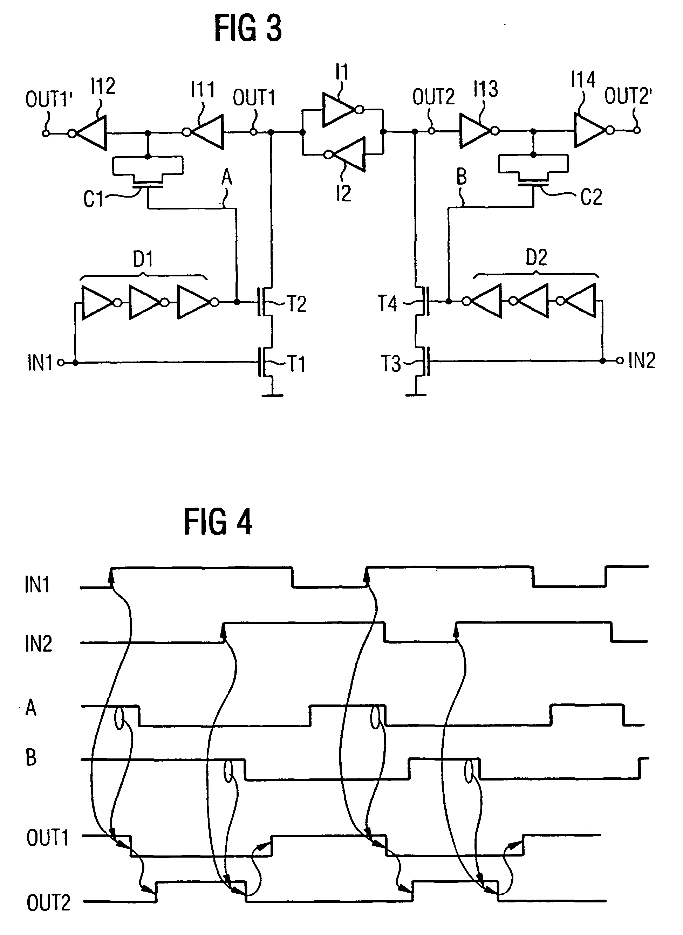

Figur 4 zeigt Signalverläufe zu der in Figur 1 dargestellten Schaltung. Es ist zu erkennen, daß die Ausgangstakte OUT1, OUT2 High-Pegel aufweisen, die sich zeitlich nicht überlappen, wobei die Zeiträume, in denen keiner dieser Takte den High-Pegel hat, sehr kurz sind.

Figur 2 zeigt ein zweites Ausführungsbeispiel der Erfindung, das ebenfalls zwischen den Ausgängen OUT1, OUT2 die beiden Inverter I1, I2, zwischen dem ersten Ausgang OUT1 und Masse die Reihenschaltung aus dem zweiten Schaltelement T2 und dem ersten Schaltelement T1 und zwischen dem zweiten Ausgang OUT2 und Masse die Reihenschaltung aus dem vierten Schaltelement T4 und dem dritten Schaltelement T3 aufweist. Der erste Eingang IN1 ist wiederum mit dem Gate des ersten Schaltelementes T1 und der zweite Eingang IN2 mit dem Gate des dritten Schaltelementes T3 verbunden. Das Gate A des zweiten Schaltelementes T2 ist mit dem Gate B des vierten Schaltelementes T4 über einen dritten Inverter I3 und einen vierten Inverter I4 verbunden, die gegenparallel zueinander angeordnet sind. Ferner ist das Gate A des zweiten Schaltelementes T2 über ein sechstes Schaltelement T6 und ein fünftes Schaltelement T5 mit Masse verbunden, während das Gate B des vierten Schaltelemente T4 über ein achtes Schaltelementes T8 und ein siebtes Schaltelement T7 mit Masse verbunden ist. Der erste Ausgang OUT1 ist mit dem Gate des siebten Schaltelementes T7 und der zweite Ausgang OUT2 mit dem Gate des fünften Schaltelementes T5 verbunden. Der zweite Eingang IN2 ist über einen fünften Inverter I5 mit dem Gate des sechsten Schaltelementes T6 und der erste Eingang IN1 ist über einen sechsten Inverter I6 mit dem Gate des achten Schaltelementes T8 verbunden.

Dem ersten Ausgang OUT1 ist ein siebter Inverter I7 und ein achter Inverter I8 nachgeschaltet, wobei am Ausgang des achten Inverter I8 ein modifizierter erster Ausgangstakt OUT1' erzeugt wird. Dem zweiten Ausgang OUT2 ist ein neunter Inverter I9 und ein zehnter Inverter I10 nachgeschaltet, wobei am Ausgang des zehnten Inverters I10 ein zweiter modifizierter Ausgangstakt OUT2' erzeugt wird. Der siebte Inverter I7 und der neunte Inverter I9 sind so dimensoniert, das durch sie eine negative Signalflanke an ihrem Eingang (das heißt den Ausgängen OUT1, OUT2) stärker verzögert wird als eine positive Flanke. Hierdurch wird erreicht, das die modifizierte Ausgangstakte OUT1', OUT2' zeitgleich eine Pegeländerung aufweisen.

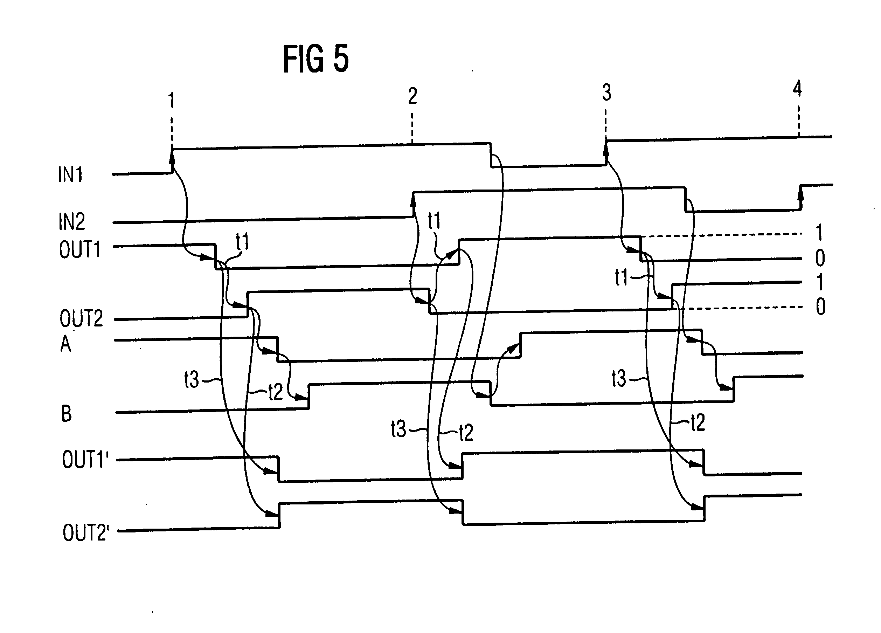

Figur 5 zeigt die entsprechenden Signalverläufe zum Ausführungsbeispiel aus Figur 2. In Figur 5 sind auch Verzögerungszeiten t₁, t₂, t₃ eingezeichnet. Die erste Verzögerungszeit t₁ ist die Verzögerung zwischen einer Flanke aus einem der Ausgänge OUT1, OUT2 gegenüber einer Flanke am anderen Ausgang. Die zweite Verzögerungszeit t₂ gilt für eine positive Flanke an den Ausgängen OUT1, OUT2. Die dritte Verzögerungszeit t₃ gilt für eine entsprechende negative Flanke. Es gilt t₂ < t₃. t₂ und t₃ sind durch entsprechende Dimensionierung der Inverter I7 bis I10 so festgelegt, daß t₁ + t₂ = t₃ gilt. Somit treten die Flanken der modifizierten Ausgangstakte OUT1', OUT2' immer gleichzeitig auf.

Figur 3 zeigt ein weiteres Ausführungsbeispiel der Erfindung, das sich vom Ausführungsbeispiel gemäß Figur 1 darin unterscheidet, daß dem ersten Ausgang OUT1 ein elfter Inverter I11 und ein zwölfter Inverter I12 nachgeschaltet sind, wobei am Ausgang des zwölften Inverters I12 der erste modifizierte Ausgangstakt OUT1' erzeugt wird. Dem zweiten Ausgang OUT2 ist ein dreizehnter Inverter I13 und ein vierzehnter Inverter I14 nachgeschaltet, wobei am Ausgang des vierzehnten Inverters I14 der zweite modifizierte Ausgangstakt OUT2' erzeugt wird. Bei diesem Ausführungsbeispiel weisen die vier Inverter I11 bis I14 wenigstens annähernd symmetrisches Schaltverhalten auf, das heißt, sie verzögern sowohl positive als auch negative Flanken ihres Eingangssignals in etwa um die gleiche Zeitspanne.

Um trotzdem die positive Flanke der Ausgangstakte OUT1, OUT2 weniger stark zu verzögern, als deren negative Flanke, ist der Ausgang des elften Inverters I11 über eine erste spannungsabhängige Kapazität C1 mit dem Gate A des zweiten Schaltelementes T2 und der Ausgang des dreizehnten Inverters I13 über eine zweite spannungsabhängige Kapazität C2 mit dem Gate B des vierten Schaltelements T4 verbunden. Die spannungsabhängigen Kapazitäten C1, C2 sind durch je einen n-Kanal-Transistor realisiert, dessen Source und Drain mit dem Ausgang des jeweiligen Inverters I11, I13 und dessen Gate mit dem Gate A des zweiten Schaltelementes T2 bzw. dem Gate B des vierten Schaltelements T4 verbunden ist. Wenn am Gate der Kapazitäten C1, C2 ein hohes Potential anliegt, ist deren Wert größer, als wenn am Gate ein niedriges Potential anliegt. Dies liegt daran, daß bei einem hohen Gate-Potential der Kanal des die jeweilige Kapazität C1, C2 bildenden n-Kanal-Transistors leitet, während er bei einem niedrigen Gate-Potential sperrt. Somit ergibt sich eine jeweils unterschiedliche effektive Kapazität.

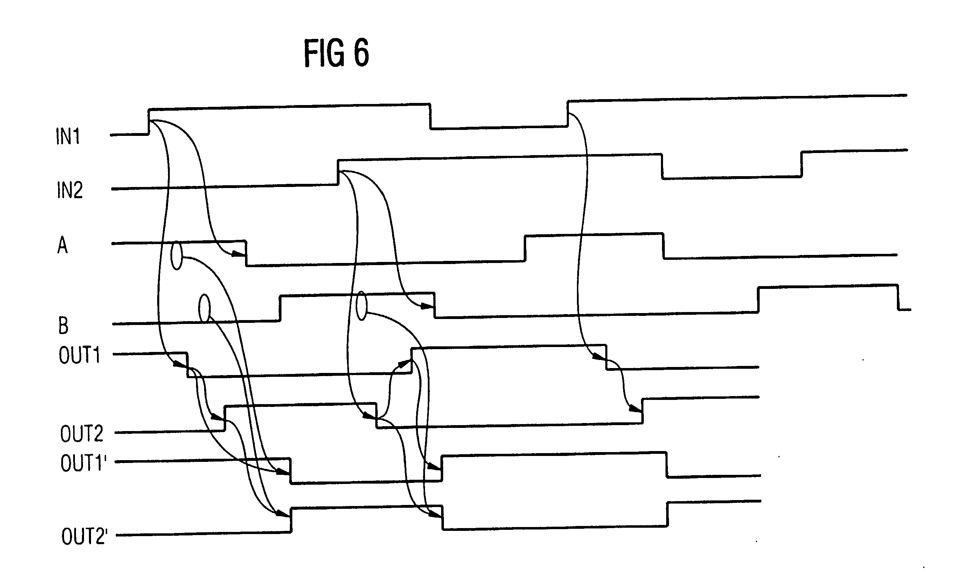

Figur 6 zeigt die Signalverläufe zum Ausführungsbeispiel gemäß Figur 3.

Bei anderen Ausführungsbeispielen kann die Erzeugung der modifizierten Ausgangstakte OUT1', OUT2', alternativ zu dem in Figur 2 dargestellten Ausführungsbeispiel, auch mit einem siebten Inverter I7 und einem neunten Inverter I9 erfolgen, die symmetrisches Schaltverhalten haben, wenn an deren Ausgängen die spannungsabhängigen Kapazitäten C1, C2 vom Ausführungsbeispiel gemäß Figur 3 vorgesehen sind, die sie mit den entsprechenden Gates A, B des zweiten Schaltelementen T2 bzw. vierten Schaltelementes T4 verbinden. Ebenso ist es möglich, beim Ausführungsbeispiel gemäß Figur 3 die spannungsabhängigen Kapazitäten C1, C2 wegzulassen und statt dessen den elften Inverter I11 und den dreizehnten Inverter I13 mit jeweils asymmetrischem Schaltverhalten auszuführen, wie dies bezüglich des siebten Inverters I7 und des neunten Inverters I9 beim Ausführungsbeispiel gemäß Figur 2 erläutert wurde.

Es sind weitere Ausführungsbeispiele der Erfindung möglich, bei denen die Reihenfolge des ersten Schaltelementes T1 und zweiten Schaltelementes T2 sowie des dritten Schaltelementes T3 und vierten Schaltelementes T4 in den Reihenschaltungen, die die Ausgänge OUT1, OUT2 mit Masse verbinden, umgekehrt wird. Allerdings hat sich gezeigt, daß die in den Figuren 1 bis 3 dargestellte Reihenfolge dieser Schaltelemente T1 bis T4 vorteilhaft ist.

Für die Funktion der Erfindung ist es wichtig, daß die beiden Eingangstakte an den Eingängen IN1, IN2 im wesentlichen dieselbe Frequenz aufweisen, wobei ihre Phasenlage jedoch beliebig sein kann. Die erfindungsgemäße integrierte Schaltung erzeugt aus diesen Eingangstakten an den Ausgängen OUT1, OUT2 Ausgangstakte, die ebenfalls dieselbe Frequenz aufweisen, deren High-Pegel sich zeitlich jedoch nicht überlappen. Es ist beispielsweise möglich, einen der Eingangstakte aus dem anderen durch Invertierung zu erzeugen.

## Patentansprüche

1. Integrierte Schaltung
- mit zwei Eingängen (IN1, IN2) zur Zuführung je eines Eingangstaktes,
- mit zwei Ausgängen (OUT1, OUT2) zur Ausgabe je eines Ausgangstaktes, wobei erste logische Pegel (1) der Ausgangstakte sich zeitlich nicht überlappen,
- mit einem ersten (I1) und einem zweiten (I2) Inverter, die antiparallel zueinander angeordnet sind und die beiden Ausgänge (OUT1, OUT2) miteinander verbinden,
- mit einer Reihenschaltung aus einem ersten (T1) und einem zweiten (T2) Schaltelement, über die der erste Ausgang (OUT1) mit einem Versorgungspotential (Masse) verbunden ist,
- mit einer Reihenschaltung aus einem dritten (T3) und einem vierten (T4) Schaltelement, über die der zweite Ausgang (OUT2) mit dem Versorgungspotential (Masse) verbunden ist,
- deren erster Eingang (IN1) mit einem Steueranschluß des ersten Schaltelementes (T1) verbunden ist,
- deren zweiter Eingang (IN2) mit einem Steueranschluß des dritten Schaltelementes (T3) verbunden ist,
- mit einer ersten Schaltungseinheit (D1; T5, T6), die mit einem Steueranschluß des zweiten Schaltelementes (T2) verbunden ist und die diesem während des Betriebs der Schaltung ein Signal (A) zuführt, das vom dem ersten Eingang (IN1)zuzuführenden Eingangstakt abgeleitet ist,
- und mit einer zweiten Schaltungseinheit (D2; T7, T8), die mit einem Steueranschluß des vierten Schaltelementes (T4) verbunden ist und die diesem während des Betriebs der Schaltung ein Signal (B) zuführt, das vom dem zweiten Eingang (IN2) zuzuführenden Eingangstakt abgeleitet ist.

2. Integrierte Schaltung nach Anspruch 1,
- mit einem dritten (I3) und einem vierten (I4) Inverter, die antiparallel zueinander angeordnet sind und die die Steueranschlüsse des zweiten (T2) und des vierten (T4) Schaltelementes miteinander verbinden,
- deren erste Schaltungseinheit eine Reihenschaltung eines fünften (T5) und eines sechsten (T6) Schaltelementes aufweist, über die der Steueranschluß des zweiten Schaltelementes (T2) mit dem Versorgungspotential (Masse) verbunden ist,
- deren zweite Schaltungseinheit eine Reihenschaltung eines siebten (T7) und eines achten (T8) Schaltelementes aufweist, über die der Steueranschluß des vierten Schaltelementes (T4) mit dem Versorgungspotential (Masse) verbunden ist,
- bei der ein Steueranschluß des fünften Schaltelementes (T5) mit dem zweiten Ausgang (OUT2) verbunden ist,
- bei der ein Steueranschluß des siebten Schaltelementes (T7) mit dem ersten Ausgang (OUT1) verbunden ist,
- mit einem fünften Inverter (I5), über den der zweite Eingang (IN2) mit einem Steueranschluß des sechsten Schaltelementes (T6) verbunden ist,
- und mit einem sechsten Inverter (I6), über den der erste Eingang (IN1) mit einem Steueranschluß des achten Schaltelementes (T8) verbunden ist.

3. Integrierte Schaltung nach Anspruch 1,
- deren Schaltungseeinheiten je ein invertierendes Verzögerungselement (D1, D2) aufweisen,
- deren erstes invertierendes Verzögerungselement (D1) den ersten Eingang (IN1) mit dem Steueranschluß des zweiten Schaltelementes (T2) verbindet
- und deren zweites invertierendes Verzögerungselement (D2) den zweiten Eingang (IN2) mit dem Steueranschluß des vierten Schaltelementes (T4) verbindet.

4. Integrierte Schaltung nach einem der Ansprüche 1 bis 3, deren Ausgänge (OUT1, OUT2) jeweils mit einer Verzögerungseinheit (C1, C2; I7, I9) verbunden sind, die eine unterschiedliche Verzögerung für die beiden Flankenarten des jeweiligen Ausgangstaktes bewirkt.

5. Integrierte Schaltung nach Anspruch 4,
- deren Verzögerungseinheiten jeweils einen Kondensator (C1, C2) aufweisen mit einer Kapazität, die von der Polarität der über dem Kondensator abfallenden Spannung abhängt,
- deren erster Ausgang (OUT1) über den ersten Kondensator (C1) mit dem Steueranschluß des zweiten Schaltelementes (T2) verbunden ist
- und deren zweiter Ausgang (OUT2) über den zweiten Kondensator (C2) mit dem Steueranschluß des vierten Schaltelementes (T4) verbunden ist.

6. Integrierte Schaltung nach Anspruch 4,
deren Verzögerungseinheiten jeweils einen Inverter (I7, I9) aufweisen, dessen Eingang mit dem entsprechenden Ausgang (OUT1, OUT2) verbunden ist und der eine unterschiedliche Verzögerung der beiden Flankenarten bewirkt.

7. Integrierte Schaltung nach Anspruch 1,
- deren erster Ausgang (OUT1) über das zweite Schaltelement (T2) mit dem ersten Schaltelement (T1) verbunden ist
- und deren zweiter Ausgang (OUT2) über das vierte Schaltelement (T4) mit dem dritten Schaltelement (T3) verbunden ist.

## Claims

1. Integrated circuit
- having two inputs (IN1, IN2) for each supplying one input clock,
- having two outputs (OUT1, OUT2) for each outputting one output clock, in which case first logic levels (1) of the output clocks do not overlap in time,
- having a first (I1) and a second (I2) inverter which are arranged back to back and connect the two outputs (OUT1, OUT2) to one another,
- having a series circuit comprising a first (T1) and a second (T2) switching element, via which the first output (OUT1) is connected to a supply potential (earth),
- having a series circuit comprising a third (T3) and a fourth (T4) switching element, via which the second output (OUT2) is connected to the supply potential (earth),
- whose first input (IN1) is connected to a control connection of the first switching element (T1),
- whose second input (IN2) is connected to a control connection of the third switching element (T3),
- having a first circuit unit (D1; T5, T6) which is connected to a control connection of the second switching element (T2) and which, during operation of the circuit, supplies this second switching element (T2) with a signal (A) which is derived from the input clock to be supplied to the first input (IN1),
- and having a second circuit unit (D2; T7, T8) which is connected to a control connection of the fourth switching element (T4) and which, during operation of the circuit, supplies this second switching element (T2) with a signal (B) which is derived from the input clock to be supplied to the second input (IN2).

2. Integrated circuit according to Claim 1,
- having a third (I3) and a fourth (I4) inverter, which are arranged back to back and connect the control connections of the second (T2) and of the fourth (T4) switching element to one another,
- whose first circuit unit has a series circuit comprising a fifth (T5) and a sixth (T6) switching element, via which the control connection of the second switching element (T2) is connected to the supply potential (earth),
- whose second circuit unit has a series circuit comprising a seventh (T7) and an eighth (T8) switching element, via which the control connection of the fourth switching element (T4) is connected to the supply potential (earth),
- in which a control connection of the fifth switching element (T5) is connected to the second output (OUT2),
- in which a control connection of the seventh switching element (T7) is connected to the first output (OUT1),
- having a fifth inverter (I5) via which the second input (IN2) is connected to a control connection of the sixth switching element (T6),
- and having a sixth inverter (I6) via which the first input (IN1) is connected to a control connection of the eighth switching element (T8).

3. Integrated circuit according to Claim 1,
- whose circuit units each have an inverting delay element (D1, D2),
- whose first inverting delay element (D1) connects the first input (IN1) to the control connection of the second switching element (T2),
- and whose second inverting delay element (D2) connects the second input (IN2) to the control connection of the fourth switching element (T4).

4. Integrated circuit according to one of Claims 1 to 3, whose outputs (OUT1, OUT2) are each connected to a delay unit (C1, C2; I7, I9) which produces a different delay for the two edge types of the respective output clock.

5. Integrated circuit according to Claim 4,
- whose delay units each have a capacitor (C1, C2) with a capacitance which depends on the polarity of the voltage drop across the capacitor,
- whose first output (OUT1) is connected via the first capacitor (C1) to the control connection of the second switching element (T2),
- and whose second output (OUT2) is connected via the second capacitor (C2) to the control connection of the fourth switching element (T4).

6. Integrated circuit according to Claim 4, whose delay units each have an inverter (I7, I9) whose input is connected to the corresponding output (OUT1, OUT2) and which produces a different delay for the two edge types.

7. Integrated circuit according to Claim 1,
- whose first output (OUT1) is connected via the second switching element (T2) to the first switching element (T1),
- and whose second output (OUT2) is connected via the fourth switching element (T4) to the third switching element (T3).

## Revendications

1. Circuit intégré
- comprenant deux entrées (IN1, IN2) pour l'entrée de respectivement un signal d'horloge d'entrée,
- comprenant deux sorties (OUT1, OUT2) pour la sortie de respectivement un signal d'horloge de sortie, des premiers niveaux (1) logiques des signaux d'horloge de sortie ne se chevauchant pas dans le temps,
- comprenant un premier (I1) et un deuxième (I2) inverseurs, qui sont montés de façon anti-parallèle l'un par rapport à l'autre et qui relient entre elles les deux sorties (OUT1, OUT2),
- comprenant un circuit série qui est constitué d'un premier (T1) et d'un deuxième (T2) éléments de commutation et par lequel la première sortie (OUT1) est reliée à un potentiel d'alimentation (Masse),
- comprenant un circuit série qui est constitué d'un troisième (T3) et d'un quatrième (T4) éléments de commutation et par lequel la deuxième sortie (OUT2) est reliée au potentiel d'alimentation (Masse),
- dont la première entrée (IN1) est reliée à une borne de commande du premier élément (T1) de commutation,
- dont la deuxième entrée (IN2) est reliée à une borne de commande du troisième élément (T3) de commutation,
- comprenant une première unité (D1 ; T5, T6) de circuits qui est reliée à une borne de commande du deuxième élément (T2) de commutation et qui envoie à celui-ci, pendant le fonctionnement du circuit, un signal (A) qui est dérivé du signal d'horloge d'entrée à envoyer par la première entrée (IN1),
- comprenant une deuxième unité (D2 ; T7, T8) de circuit, qui est reliée à une borne de commande du quatrième élément (T4) de commutation et qui envoie à celui-ci, pendant le fonctionnement du circuit, un signal (B) qui est dérivé du signal d'horloge d'entrée à envoyer par la deuxième entrée (IN2).

2. Circuit intégré suivant la revendication 1,
- comprenant un troisième (I3) et un quatrième (I4) inverseurs, qui sont montés anti-parallèlement l'un par rapport à l'autre et qui relient entre elles les bornes de commande du deuxième (T2) et du quatrième (T4) éléments de commutation,
- dont la première unité de circuit comporte un circuit série qui est constitué d'un cinquième (T5) et d'un sixième (T6) éléments de commutation et par lequel la borne de commande du deuxième élément (T2) de commutation est reliée au potentiel d'alimentation (Masse),
- dont la deuxième unité de circuit comporte un circuit série qui est constitué d'un septième (T7) et d'un huitième (T8) éléments de commutation et par lequel la borne de commande du quatrième élément (T4) de commutation est reliée au potentiel d'alimentation (Masse),
- dans lequel une borne de commande du cinquième élément (T5) de commutation est reliée à la deuxième sortie (OUT2),
- dans lequel une borne de commande du septième élément (T7) de commutation est reliée à la première sortie (OUT1),
- comprenant un cinquième inverseur (I5) par lequel la deuxième entrée (IN2) est reliée à une borne de commande du sixième élément (T6) de commutation,
- et comprenant un sixième inverseur (I6) par lequel la première entrée (IN1) est reliée à une borne de commande du huitième élément (T8) de commutation.

3. Circuit intégré suivant la revendication 1,
- dont les unités de circuit ont chacune un élément (D1, D2) inverseur de temporisation,
- dont le premier élément (D1) inverseur de temporisation relie la première entrée (IN1) à la borne de commande du deuxième élément (T2) de commutation,
- et dont le deuxième élément (D2) inverseur de temporisation relie la deuxième entrée (IN2) à la borne de commande du quatrième élément (T4) de commutation.

4. Circuit intégré suivant l'une des revendications 1 à 3, dont les sorties (OUT1, OUT2) sont reliées, respectivement, à une unité (C1, C2 ; I7, I9) de temporisation, qui provoque une temporisation différente pour les deux types de front du signal d'horloge de sortie respectif.

5. Circuit intégré suivant la revendication 4,
- dont les unités de temporisation ont, respectivement, un condensateur (C1, C2) ayant une capacité qui dépend de la polarité de la tension chutant aux bornes du condensateur,
- dont la première sortie (OUT1) est reliée par le premier condensateur (C1) à la borne de commande du deuxième élément (T2) de commutation,
- et dont la deuxième sortie (OUT2) est reliée par le deuxième condensateur (C2) à la borne de commande du quatrième élément (T4) de commutation.

6. Circuit intégré suivant la revendication 4,
dont les unités de temporisation ont, respectivement, un inverseur (I7, I9) dont l'entrée est reliée à la sortie (OUT1, OUT2) correspondante et qui provoque une temporisation différente des deux types de front.

7. Circuit intégré suivant la revendication 1,
- dont la première sortie (OUT1) est reliée par le deuxième élément (T2) de commutation au premier élément (T1) de commutation
- et dont la deuxième sortie (OUT2) est reliée par le quatrième élément (T4) de commutation au troisième élément (T3) de commutation.
